# EUROPÄISCHE PATENTSCHRIFT

(11) **EP 2 149 159 B1**
(45) Veröffentlichungstag und Bekanntmachung des Hinweises auf die Patenterteilung: **01.03.2017**
(21) Anmeldenummer: 08748775.7
(22) Anmeldetag: 24.04.2008
(51) Int. Cl.: H01L 33/00

(54) **OPTOELEKTRONISCHER HALBLEITERKÖRPER UND VERFAHREN ZUR HERSTELLUNG EINES SOLCHEN**
OPTO-ELECTRONIC SEMICONDUCTOR BODY AND METHOD FOR THE PRODUCTION THEREOF
CORPS SEMI-CONDUCTEUR OPTO-ÉLECTRONIQUE ET SON PROCÉDÉ DE RÉALISATION

(30) Priorität: 26.04.2007 DE 102007019773; 16.05.2007 DE 102007022947
(43) Veröffentlichungstag der Anmeldung: 03.02.2010
(73) Patentinhaber: OSRAM Opto Semiconductors GmbH, 93055 Regensburg (DE)
(72) Erfinder: ENGL, Karl, 93080 Pentling (DE); RODE, Patrick, 93047 Regensburg (DE); HÖPPEL, Lutz, 93087 Alteglofsheim (DE); SABATHIL, Matthias, 93059 Regensburg (DE)
(74) Vertreter: Epping - Hermann - Fischer
(86) Internationale Anmeldenummer: PCT/DE2008/000702
(87) Internationale Veröffentlichungsnummer: WO 2008/131735

(56) Entgegenhaltungen:
- DE-A1-102005 007 601
- US-A1- 2004 184 498

## Beschreibung

Diese Patentanmeldung beansprucht die Priorität der deutschen Patentanmeldungen 102007019773.1 und 102007022947.1.

Die Druckschrift DE-A-10 2005 007 601 beschreibt verschiedene optoelektronische Halbleiterkörper und Verfahren zu ihrer Herstellung.

Die Erfindung betrifft einen optoelektronischen Halbleiterkörper und ein Verfahren zur Herstellung eines optoelektronischen Halbleiterkörpers.

Es ist eine Aufgabe der vorliegenden Erfindung einen optoelektronischen Halbleiterkörper mit verbesserter Effizienz und/oder verbesserten elektrischen Eigenschaften anzugeben.

Diese Aufgaben werden durch einen optoelektronischen Halbleiterkörper und durch ein Verfahren zum Herstellen eines optoelektronischen Halbleiterkörpers gemäß der unabhängigen Patentansprüche gelöst. Die Erfindung betrifft einen optoelektronischen Halbleiterkörper gemäß Anspruch 1 und ein Verfahren zur Herstellen eines optoelektronischen Halbleiterkörpers gemäß Anspruch 12.

Ausgestaltungen und Weiterbildungen der Erfindung sind in den jeweils abhängigen Ansprüchen angegeben, deren Offenbarungsgehalt hiermit ausdrücklich in die Beschreibung mit aufgenommen wird.

Ein optoelektronischer Halbleiterkörper gemäß der Erfindung weist eine Halbleiterschichtenfolge auf, die eine zur Erzeugung von elektromagnetischer Strahlung geeignete aktive Schicht enthält.

Die aktive Schicht weist einen pn-Übergang, eine Doppelheterostruktur, einen Einfachquantentopf (SQW, single quantum well) oder eine Mehrfachquantentopfstruktur (MQW, multi quantum well) zur Strahlungserzeugung auf. Die Bezeichnung Quantentopfstruktur entfaltet hierbei keine Bedeutung hinsichtlich der Dimensionalität der Quantisierung. Sie umfasst somit unter anderem Quantentröge, Quantendrähte und Quantenpunkte und jede Kombination dieser Strukturen. Beispiele für MQW-Strukturen sind in den Druckschriften WO 01/39282, US 5,831,277, US 6,172,382 B1 und US 5,684,309 beschrieben, deren Offenbarungsgehalt insofern hiermit durch Rückbezug aufgenommen wird.

Der Halbleiterkörper ist zur Emission elektromagnetischer Strahlung von einer Vorderseite vorgesehen. An einer der Vorderseite gegenüberliegenden Rückseite sind eine erste und eine zweite elektrische Anschlussschicht angeordnet. Die erste und die zweite elektrische Anschlussschicht sind mittels einer Trennschicht elektrisch gegeneinander isoliert.

"An einer der Vorderseite gegenüberliegenden Rückseite angeordnet" bedeutet vorliegend, dass zumindest ein Teil der ersten beziehungsweise zweiten elektrischen Anschlussschicht der Halbleiterschichtenfolge in Richtung von der Vorderseite zur Rückseite hin nachfolgt. Es ist jedoch nicht notwendig, dass die gesamte erste beziehungsweise zweite elektrische Anschlussschicht an der Rückseite angeordnet ist. Vielmehr erstreckt sich ein Teilbereich der zweiten elektrischen Anschlussschicht von der Rückseite durch einen Durchbruch der aktiven Schicht hindurch in Richtung zu der Vorderseite hin. Die erste elektrische Anschlussschicht, die zweite elektrische Anschlussschicht und die Trennschicht sind jedoch derart ausgebildet, dass sie - insbesondere an der Rückseite - lateral überlappen.

Bei einer Ausgestaltung des Halbleiterkörpers reflektieren die erste und/oder die zweite elektrische Anschlussschicht einen von der aktiven Zone in Richtung zu der Rückseite hin emittierten Teil der elektromagnetischen Strahlung in Richtung der Vorderseite.

Vorteilhafterweise ist die lichtemittierende Vorderseite der Halbleiterschichtenfolge frei von elektrischen Kontaktstellen wie Bondpads. Die Gefahr einer Abschattung und/oder Absorption eines Teils der von der aktiven Zone im Betrieb emittierten elektromagnetischen Strahlung durch die elektrischen Kontaktstellen wird auf diese Weise reduziert. Auf aufwendige Verfahrensschritte in Zusammenhang mit der Herstellung einer solchen Kontaktstelle auf der Vorderseite der Halbleiterschichtenfolge, etwa das Polieren der vorderseitigen Oberfläche der Halbleiterschichtenfolge und/oder die Herstellung von Metallstegen zur Stromaufweitung, die eine große Dicke aber geringe laterale Ausdehnung aufweisen, und/oder auf Maßnahmen die die Strominjektion in Bereiche der Halbleiterschichtenfolge unterhalb der elektrischen Kontaktstelle einschränken oder verhindern, etwa das Ausbilden einer elektrisch isolierenden Schicht, einer Schottky-Barriere und/oder eines ionenimplantierten Bereichs unterhalb der Kontaktstelle, kann beispielsweise mit Vorteil verzichtet werden.

Bei einer weiteren Ausgestaltung ist der Halbleiterkörper ein Dünnfilm-Leuchtdiodenchip. Insbesondere weist er an seiner Rückseite ein Trägersubstrat auf. Bei einer Ausgestaltung sind die erste und die zweite Anschlussschicht zumindest stellenweise zwischen der Halbleiterschichtenfolge und dem Trägersubstrat angeordnet.

Ein Dünnfilm-Leuchtdiodenchip zeichnet sich durch mindestens eines der folgenden charakteristischen Merkmale aus:
- an einer zu einem Trägerelement, insbesondere dem Trägersubstrat, hingewandten Hauptfläche der strahlungserzeugenden Halbleiterschichtenfolge, bei der es sich insbesondere um eine strahlungserzeugende Epitaxie-Schichtenfolge handelt, ist eine reflektierende Schicht aufgebracht oder ausgebildet, die zumindest einen Teil der in der Halbleiterschichtenfolge erzeugten elektromagnetischen Strahlung in diese zurückreflektiert;
- der Dünnfilm-Leuchtdiodenchip weist ein Trägerelement auf, bei dem es sich nicht um das Wachstumssubstrat handelt, auf dem die Halbleiterschichtenfolge epitaktisch gewachsen wurde, sondern um ein separates Trägerelement, das nachträglich an der Halbleiterschichtenfolge befestigt wurde;
- die Halbleiterschichtenfolge weist eine Dicke im Bereich von 20 *µ*m oder weniger, insbesondere im Bereich von 10 *µ*m oder weniger auf;
- die Halbleiterschichtenfolge ist frei von einem Aufwachssubstrat. Vorliegend bedeutet "frei von einem Aufwachssubstrat, dass ein gegebenenfalls zum Aufwachsen benutztes Aufwachssubstrat von der Halbleiterschichtenfolge entfernt oder zumindest stark gedünnt ist. Insbesondere ist es derart gedünnt, dass es für sich oder zusammen mit der Epitaxie-Schichtenfolge alleine nicht freitragend ist. Der verbleibende Rest des stark gedünnten Aufwachssubstrats ist insbesondere als solches für die Funktion eines Aufwachssubstrates ungeeignet; und
- die Halbleiterschichtenfolge enthält mindestens eine Halbleiterschicht mit zumindest einer Fläche, die eine Durchmischungsstruktur aufweist, die im Idealfall zu einer annähernd ergodischen Verteilung des Lichtes in der Halbleiterschichtenfolge führt, das heißt, sie weist ein möglichst ergodisch stochastisches Streuverhalten auf.

Ein Grundprinzip eines Dünnfilm-Leuchtdiodenchips ist beispielsweise in der Druckschrift I. Schnitzer et al., Appl. Phys. Lett. 63 (16) 18. Oktober 1993, Seiten 2174 - 2176 beschrieben, deren Offenbarungsgehalt insofern hiermit durch Rückbezug aufgenommen wird. Beispiele für Dünnfilm-Leuchtdiodenchips sind in den Druckschriften EP 0905797 A2 und WO 02/13281 A1 beschrieben, deren Offenbarungsgehalt insofern hiermit ebenfalls durch Rückbezug aufgenommen wird.

Ein Dünnfilm-Leuchtdiodenchip ist in guter Näherung ein Lambert'scher Oberflächenstrahler und eignet sich von daher beispielsweise gut für die Anwendung in einem Scheinwerfer, etwa einem Kraftfahrzeugscheinwerfer.

Bei einer weiteren Ausgestaltung weist der Halbleiterkörper zwischen der Halbleiterschichtenfolge und der ersten und/oder der zweiten elektrischen Anschlussschicht zumindest stellenweise eine halbleitende oder elektrisch isolierende Spiegelschicht auf. Ein Brechungsindex der Spiegelschicht weicht beispielsweise um 1 oder mehr von dem Brechungsindex einer Schicht der Halbleiterschichtenfolge ab, die der Spiegelschicht in Richtung zur Vorderseite nachfolgt und insbesondere an diese angrenzt. Bei einer Ausgestaltung enthält die Spiegelschicht ein Dielektrikum wie SiO₂. Bei einer weiteren Ausgestaltung ist die Trennschicht zumindest stellenweise als elektrisch isolierende Spiegelschicht ausgebildet.

Bei einer Weiterbildung enthält die halbleitende oder elektrisch isolierende Spiegelschicht einen verteilten Bragg-Reflektor (DBR, Distributed Bragg Reflector), der mindestens ein Schichtenpaar mit alternierend hohem und niedrigem Brechungsindex enthält.

Die halbleitende oder elektrisch isolierende Spiegelschicht bedeckt bei einer Ausgestaltung 50 Prozent oder mehr einer rückseitigen Hauptfläche des Halbleiterschichtstapels. Bei einer weiteren Ausgestaltung weist die Spiegelschicht eine Mehrzahl von Öffnungen auf, durch welche Teilbereiche der ersten und/oder der zweiten elektrischen Anschlussschicht zu der Halbleiterschichtenfolge verlaufen.

Die halbleitende oder elektrisch isolierende Spiegelschicht weist - beispielsweise aufgrund der Änderung des Brechungsindex - einen besonders hohen Reflektionskoeffizienten auf, so dass sie von der aktiven Zone in Richtung der Rückseite emittierte elektromagnetische Strahlung besonders effizient in Richtung der Vorderseite reflektiert. Mittels einer Spiegelschicht, die eine Mehrzahl von Öffnungen aufweist, durch welche Teilbereiche der ersten und/oder der zweiten elektrischen Anschlussschicht hindurch verlaufen, wird der Betriebsstrom besonders homogen in die Halbleiterschichtenfolge eingeprägt.

Bei einer weiteren Ausgestaltung weist die Halbleiterschichtenfolge eine der Rückseite benachbarte Stromaufweitungsschicht auf. Die Stromaufweitungsschicht enthält beispielsweise ein transparentes leitfähiges Oxid (TCO, transparent conducting oxide). Mittels der Stromaufweitungsschicht wird die Homogenität der Stromeinprägung weiter verbessert.

Bei einer anderen Ausgestaltung weist die erste und/oder die zweite elektrische Anschlussschicht eine Mehrschichtstruktur auf. Beispielsweise weist die erste und/oder die zweite elektrische Anschlussschicht eine Haftvermittlungsschicht, eine Reflektorschicht und/oder eine Stromverteilungsschicht auf.

Die Haftvermittlungsschicht ist zweckmäßigerweise der Halbleiterschichtenfolge zugewandt. Vorzugsweise hat sie eine Dicke von 1 nm oder weniger, insbesondere von 0,5 nm oder weniger. Die Haftvermittlungsschicht kann beispielsweise eine Monolage und/oder eine nicht geschlossene Schicht von Atomen und/oder Molekülen sein. Die Reflektorschicht ist insbesondere der von der Halbleiterschichtenfolge abgewandten Seite der Haftvermittlungsschicht nachgeordnet und grenzt insbesondere an diese an.

Die Haftvermittlungsschicht verbessert die Haftung der Reflektorschicht an einer der ersten beziehungsweise zweiten elektrischen Anschlussschicht vorausgehenden Schicht, insbesondere einer Halbleiterschicht der Halbleiterschichtenfolge, etwa der Stromaufweitungsschicht, oder der Trennschicht. Je nach den Eigenschaften der Reflektorschicht kann auf die Haftvermittlungsschicht auch verzichtet werden.

Die Haftvermittlungsschicht weist beispielsweise Platin und/oder Titan auf. Die Reflektorschicht weist ein elektrisch leitfähiges Material, insbesondere ein Metall, mit einem hohen Reflexionskoeffizienten auf, beispielsweise Silber, oder besteht daraus.

Zusätzlich weist die erste und/oder die zweite elektrische Anschlussschicht bei einer Weiterbildung eine Stromverteilungsschicht auf, die insbesondere ein Material mit einer besonders guten elektrischen Leitfähigkeit, etwa Gold, enthält.

Bei einer weiteren Ausgestaltung des optoelektronischen Halbleiterkörpers weist die erste elektrische Anschlussschicht einen elektrischen Kontaktbereich - etwa ein Bondpad - auf, der zur elektrischen Kontaktierung des Halbleiterkörpers von seiner Vorderseite geeignet ist. Zusätzlich oder alternativ kann sie einen elektrischen Kontaktbereich aufweisen, der zur elektrischen Kontaktierung des Halbleiterkörpers von seiner Rückseite her geeignet ist. In analoger Weise kann die zweite elektrische Anschlussschicht einen Kontaktbereich aufweisen, der zur elektrischen Kontaktierung des Halbleiterkörpers von seiner Vorderseite geeignet ist und/oder einen elektrischen Kontaktbereich, der zur elektrischen Kontaktierung des Halbleiterkörpers an seiner Rückseite geeignet ist.

Ein elektrischer Kontaktbereich, der zur elektrischen Kontaktierung des Halbleiterkörpers von seiner Vorderseite geeignet ist, ist zweckmäßigerweise seitlich von der Halbleiterschichtenfolge angeordnet. Die elektrischen Kontaktbereiche können mit Vorteil großflächig ausgeführt sein, da sie die Emission elektromagnetischer Strahlung aus dem Halbleiterkörper nicht beeinträchtigen. Der Halbleiterkörper ist daher besonders gut zur Verwendung mit hohen Betriebsströmen geeignet. Anders ausgedrückt hat er mit Vorteil eine hohe Stromtragfähigkeit.

Die Anordnung der Kontaktbereiche ist vorteilhafterweise frei wählbar. Der Halbleiterkörper kann zur p-seitigen Kontaktierung und zur n-seitigen Kontaktierung der Halbleiterschichtenfolge von seiner Vorderseite her, zur p-seitigen und n-seitigen Kontaktierung von seiner Rückseite her, zur p-seitigen Kontaktierung von seiner Vorderseite her und zur n-seitigen Kontaktierung von seiner Rückseite, zur n-seitigen Kontaktierung von seiner Vorderseite her und zur p-seitigen Kontaktierung von seiner Rückseite, sowie zur n- und/oder p-seitigen Kontaktierung sowohl von der Vorder- wie von der Rückseite her vorgesehen sein. Die p-Seitige Kontaktierung wird dabei mittels der ersten elektrischen Anschlussschicht und die n-seitige Kontaktierung mittels der zweiten elektrischen Anschlussschicht hergestellt oder umgekehrt.

Bei einer weiteren Ausgestaltung weist die Halbleiterschichtenfolge eine der Vorderseite benachbarte Pufferschicht auf, die insbesondere eine geringe elektrische Leitfähigkeit besitzt. Zum Beispiel ist die Pufferschicht undotiert oder schwach n-dotiert. Bei einer Weiterbildung handelt es sich bei der Pufferschicht um eine ESD-Schützschicht (ESD, E-lectrostatic Discharge), welche die Gefahr einer Zerstörung des Halbleiterkörpers durch eine elektrostatische Entladung verringert.

Unter einer Pufferschicht mit einer geringen elektrischen Leitfähigkeit wird vorliegend eine Pufferschicht verstanden, die nicht dazu geeignet ist, einen Betriebsstrom zur aktiven Zone zu leiten, und deren elektrische Leitfähigkeit beispielsweise kleiner oder gleich 20 (Ωcm)⁻¹ ist. Bei einer Weiterbildung ist die, auch als spezifischer Leitwert bezeichnete, elektrische Leitfähigkeit kleiner oder gleich 1 (Ωcm)⁻¹. Unter einer schwachen n-Dotierung wird vorliegend eine n-Dotierung von 2 x 10¹⁷ Atome/cm³ oder weniger verstanden.

Ein erfindungsgemäßes Verfahren zur Herstellung eines optoelektronischen Halbleiterkörpers weist die folgenden Schritte auf:
- Epitaktisches Aufwachsen einer Halbleiterschichtenfolge, die eine zur Erzeugung von elektromagnetischer Strahlung geeignete aktive Schicht aufweist und zur Emission elektromagnetischer Strahlung von einer Vorderseite vorgesehen ist, auf einem Aufwachssubstrat;
- Aufbringen einer ersten elektrischen Anschlussschicht an einer der Vorderseite gegenüberliegenden Rückseite der Halbleiterschichtenfolge;
- Ausbilden eines Durchbruchs in der aktiven Schicht;
- Ausbilden einer Trennschicht an der Rückseite der Halbleiterschichtenfolge; und
- Aufbringen einer zweiten elektrischen Anschlussschicht an der Rückseite der Halbleiterschichtenfolge,
wobei die erste elektrische Anschlussschicht, die zweite elektrische Anschlussschicht und die Trennschicht lateral überlappend ausgebildet werden, ein Teilbereich der zweiten elektrischen Anschlussschicht in dem Durchbruch ausgebildet wird und die zweite elektrische Anschlussschicht mittels der Trennschicht von der ersten elektrischen Anschlussschicht isoliert wird.

Bei einer Ausgestaltung des Verfahrens werden die erste und/oder die zweite elektrische Anschlussschicht reflektierend ausgeführt.

Bei einer weiteren Ausgestaltung des Verfahrens wird nach dem Aufwachsen der Halbleiterschichtenfolge zumindest ein Teil des Aufwachssubstrats entfernt. Das Entfernen des Aufwachssubstrats kann vor oder nach dem Aufbringen der ersten oder der zweiten Anschlussschicht erfolgen. Beispielsweise wird der Teil des Aufwachssubstrats abgesprengt, etwa mittels eines Laser-Abhebeverfahrens.

Bei einer anderen Ausgestaltung wird an der Rückseite des Halbleiterkörpers ein Trägersubstrat angeordnet oder ausgebildet. Bei dem Trägersubstrat kann es sich um ein separates Trägerelement handeln, das beispielsweise mittels eines Löt- oder Klebeschritts mittels einer Lot- oder Klebstoffschicht mit der Halbleiterschichtenfolge verbunden wird. Alternativ kann die erste und/oder die zweite elektrische Anschlussschicht das Trägersubstrat darstellen. Hierzu wird die erste und/oder die zweite elektrische Anschlussschicht beispielsweise galvanisch verstärkt.

Bei einer Ausgestaltung des Verfahrens wird an der Rückseite der Halbleiterschichtenfolge stellenweise eine halbleitende oder elektrisch isolierende Spiegelschicht ausgebildet. Bei einer Weiterbildung dieser Ausgestaltung werden Öffnungen in der halbleitenden oder elektrisch isolierenden Spiegelschicht ausgebildet. Dies kann, beispielsweise mittels einer Maske, bereits beim Aufbringen der Spiegelschicht erfolgen. Alternativ können die Öffnungen, beispielsweise mittels eines Lithographie-Prozesses, nach dem Aufbringen der Spiegelschicht in dieser erzeugt werden. Die erste und/oder die zweite elektrische Anschlussschicht werden zweckmäßigerweise derart aufgebracht, dass Teilbereiche der ersten und/oder zweiten elektrischen Anschlussschicht durch die Öffnungen der Spiegelschicht hindurch verlaufen.

Bei einer anderen Ausgestaltung des Verfahrens wird an der Rückseite der Halbleiterschichtenfolge eine Stromaufweitungsschicht aufgebracht, die insbesondere ein transparentes leitfähiges Oxid enthält.

Bei einer weiteren Ausgestaltung umfasst das epitaktische Aufwachsen der Halbleiterschichtenfolge auf das Aufwachssubstrat das Aufwachsen einer Pufferschicht. Die Pufferschicht ist insbesondere zwischen der aktiven Zone und dem Aufwachssubstrat angeordnet. Sie weist beispielsweise eine geringe elektrische Leitfähigkeit auf und ist vorzugsweise undotiert oder schwach n-dotiert. Bei einer Weiterbildung des Verfahrens wird die Pufferschicht beim Entfernen des Aufwachssubstrats freigelegt.

Weitere Vorteile und vorteilhafte Ausgestaltungen ergeben sich aus den folgenden in Verbindung mit den Figuren 1 bis 8 beschriebenen Ausführungsbeispielen.

Es zeigen:
- Figuren 1A bis 1G,: schematische Querschnitte durch einen optoelektronischen Halbleiterkörper bei verschiedenen Stadien eines Verfahrens seiner Herstellung gemäß einem ersten Ausführungsbeispiel,
- Figur 2,: einen schematischen Querschnitt durch einen optoelektronischen Halbleiterkörper gemäß einem zweiten Ausführungsbeispiel,
- Figur 3,: einen schematischen Querschnitt durch einen optoelektronischen Halbleiterkörper gemäß einem dritten Ausführungsbeispiel,
- Figur 4,: einen schematischen Querschnitt durch einen optoelektronischen Halbleiterkörper gemäß einem vierten Ausführungsbeispiel,
- Figuren 5A, 5B und 6,: schematische Draufsichten auf verschiedene Ausgestaltungen von elektrischen Anschlussschichten, und
- Figuren 7 und 8,: schematische Querschnitte durch Teilbereiche des optoelektronischen Halbleiterkörpers gemäß dem dritten Ausführungsbeispiel.

In den Ausführungsbeispielen und Figuren sind gleiche oder gleich wirkende Bestandteile mit den gleichen Bezugszeichen versehen. Die Figuren und die Größenverhältnisse der in den Figuren dargestellten Elemente sind grundsätzlich nicht als maßstabsgerecht zu betrachten. Vielmehr können einzelne Elemente, etwa Schichten, zum besseren Verständnis und/oder zur besseren Darstellbarkeit übertrieben groß beziehungsweise dick dargestellt sein.

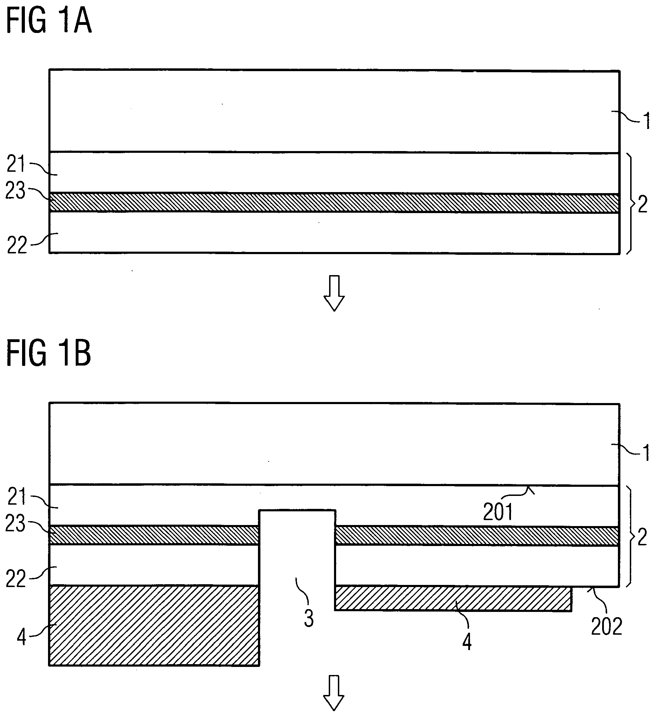

Figuren 1A bis 1G zeigen ein Verfahren zur Herstellung eines optoelektronischen Halbleiterkörpers gemäß einem ersten Ausführungsbeispiel in schematischen Schnittdarstellungen bei verschiedenen Stadien des Verfahrens.

Zunächst wird eine Halbleiterschichtenfolge 2 auf einem Aufwachssubstrat 1 epitaktisch aufgewachsen. (siehe Figur 1A). Die Halbleiterschichtenfolge 2 basiert beispielsweise auf einem III/V-Verbindungs-Halbleitermaterial oder auf einem II/VI-Verbindungs-Halbleitermaterial. Die Halbleiterschichtenfolge 2 hat vorliegend eine Dicke zwischen 5 und 7 *µ*m.

Ein III/V-Verbindungs-Halbleitermaterial weist wenigstens ein Element aus der dritten Hauptgruppe, wie beispielsweise Al, Ga, In, und ein Element aus der V-Hauptgruppe, wie beispielsweise B, N, P, As, auf. Insbesondere umfasst der Begriff "III/V-Verbindungs-Halbleitermaterial" die Gruppe der binären, ternären oder quaternären Verbindungen, die wenigstens ein Element aus der dritten Hauptgruppe und wenigstens ein Element aus der fünften Hauptgruppe enthalten, insbesondere Nitrid- und Phosphid-Verbindungs-Halbleiter. Eine solche binäre, ternäre oder quaternäre Verbindung kann zudem beispielsweise ein oder mehrere Dotierstoffe sowie zusätzliche Bestandteile aufweisen. Zu den III/V-Verbindungs-Halbleitermaterial gehören beispielsweise Nitrid-III-Verbindungs-Halbleitermaterial und Phosphid-III-Verbindungs-Halbleitermaterial, etwa GaN, GaAs, und InGaAlP.

Entsprechend weist ein II/VI-Verbindungs-Halbleitermaterial wenigstens ein Element aus der zweiten Hauptgruppe, wie beispielsweise Be, Mg, Ca, Sr, und ein Element aus der sechsten Hauptgruppe, wie beispielsweise O, S, Se, auf. Insbesondere umfasst ein II/VI-Verbindungs-Halbleitermaterial eine binäre, ternäre oder quaternäre Verbindung, die wenigstens ein Element aus der zweiten Hauptgruppe und wenigstens ein Element aus der sechsten Hauptgruppe umfasst. Eine solche binäre, ternäre oder quaternäre Verbindung kann zudem beispielsweise ein oder mehrere Dotierstoffe sowie zusätzliche Bestandteile aufweisen. Zu den II/VI-Verbindungs-Halbleitermaterialen gehören zum Beispiel ZnO, ZnMgO, CdS, CnCdS, MgBeO.

Die Halbleiterschichtenfolge 2 weist eine n-dotierte Schicht 21 auf, die vorliegend dem Aufwachssubstrat 1 benachbart ist, und eine p-dotierte Schicht 22. Die p-dotierte Schicht 22 ist vorliegend auf der von dem Aufwachssubstrat 1 abgewandten Seite der Halbleiterschichtenfolge 2 angeordnet. Zwischen der n-dotierten Schicht 21 und der p-dotierten Schicht 22 ist die aktive Zone 23 angeordnet.

Bei einer Ausgestaltung ist die Halbleiterschichtenfolge 2 als npn-Schichtenfolge ausgebildet, bei der auf der von der n-dotierten Schicht 21 abgewandten Seite der p-dotierten Schicht 22 eine weiter n-dotierte Schicht ausgebildet ist. Bei einer anderen Ausgestaltung ist die p-dotierte Schicht 22 dem Aufwachssubstrat 1 benachbart und die n-dotierte Schicht 21 ist von dem Aufwachssubstrat 1 abgewandt.

Bei einer Variante des Verfahrens wird auf dem Aufwachssubstrat 1 vor dem Aufwachsen der Halbleiterschichtenfolge 2 eine Pufferschicht aufgebracht, insbesondere epitaktisch aufgewachsen (in den Figuren nicht dargestellt). Die Pufferschicht bewirkt beispielsweise eine Anpassung der Gitterkonstanten zwischen dem Aufwachssubstrat 1 und einer nachfolgend auf die Pufferschicht aufgewachsenen Schicht der Halbleiterschichtenfolge 2. Bei einer zweckmäßigen Ausgestaltung ist die Pufferschicht undotiert oder schwach n-dotiert. Beispielsweise beträgt die Konzentration eines oder mehrerer n-Dotierstoffe der Pufferschicht 2 x 10¹⁷ Atome/cm³ oder weniger.

Die undotierte oder schwach n-dotierte Pufferschicht ist nicht dazu geeignet, vom Betriebsstrom des Halbleiterkörpers durchflossen zu werden. Dies wirkt sich jedoch nicht nachteilig aus, da der Halbleiterkörper nicht dazu vorgesehen ist, durch das Aufwachssubstrat 1 oder von einer dem Aufwachssubstrat 1 zugewandten Seite des Halbleiterschichtstapels 2 her mit dem Betriebsstrom versorgt zu werden. Vielmehr verringert die Pufferschicht bei dem fertig gestellten Halbleiterkörper die Gefahr, dass dieser durch eine elektrostatische Entladung beschädigt oder zerstört wird.

Anschließend wird in der aktiven Zone 23 mindestens ein Durchbruch ausgebildet (siehe Figur 1B). Hierzu wird, beispielsweise mittels Ätzen durch eine Maske hindurch, ausgehend von einer zweiten Hauptfläche 202 der Halbleiterschichtenfolge 2 eine Vertiefung 3 in der Halbleiterschichtenfolge 2 erzeugt. Vorzugsweise werden mehrere separate Durchbrüche 3 ausgebildet, wodurch mit Vorteil eine besonders homogene laterale Stromverteilung erzielt wird.

Die Vertiefung 3 verläuft von der zweiten Hauptfläche 202 in Richtung einer der zweiten Hauptfläche 202 gegenüber liegenden ersten Hauptfläche 201 der Halbleiterschichtenfolge 2. Die Vertiefung 3 hat beispielsweise die Form eines Kreiszylinders oder eines elliptischen Zylinders, eines Quaders, eines Kegels oder Kegelstumpfs, einer Pyramide oder eines Pyramidenstumpfs. Alternativ kann die Vertiefung 3 auch als Graben ausgebildet sein. Vorzugsweise hat der Graben eine im Wesentlichen ebene Bodenfläche. Bei einer Ausgestaltung vergrößert sich der Querschnitt des Grabens von der Bodenfläche zur zweiten Hauptfläche 202 hin.

Vor oder nach der Ausbildung der Vertiefung 3 wird eine erste Kontaktschicht 4 auf der zweiten Hauptfläche 202 aufgebracht, beispielsweise aufgedampft. Die erste Kontaktschicht 4 weist vorzugsweise ein Material, insbesondere ein Metall, mit einem hohen Reflexionskoeffizienten auf, etwa Silber. Die erste Kontaktschicht 4 kann erste und zweite Teilgebiete aufweisen, deren Schichtdicken sich voneinander unterscheiden. Beispielsweise haben die ersten Teilgebiete eine geringere Schichtdicke als die zweiten Teilgebiete.

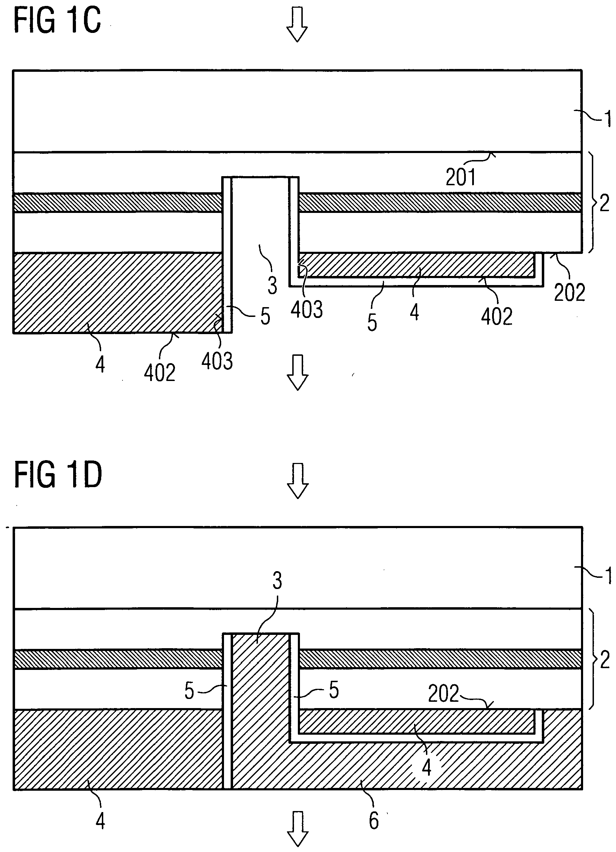

Nachfolgend wird eine Trennschicht 5 auf einem Teil der Oberfläche der Vertiefung 3 und auf einem Teil der Oberfläche der ersten elektrischen Anschlussschicht 4 ausgebildet (siehe Figur 1C). Beispielsweise bedeckt die Trennschicht 5 eine umlaufende Seitenwand oder Seitenwände der Vertiefung 3 zumindest stellenweise, vorzugsweise jedoch vollständig. Zweckmäßigerweise erstreckt sich die Trennschicht 5 in der Vertiefung 3 von der zweiten Hauptfläche 202 zumindest bis zur aktiven Zone 23 und bevorzugt bis zur Bodenfläche der Vertiefung 3.

Die Trennschicht 5 bedeckt zudem zweckmäßigerweise der Vertiefung 3 benachbarte und insbesondere an die Vertiefung 3 angrenzende Seitenflächen 403 der ersten elektrischen Anschlussschicht 4. Zudem bedeckt die Trennschicht 5 vorliegend die von der Halbleiterschichtenfolge 2 abgewandte Hauptfläche 402 der ersten elektrischen Anschlussschicht 4 stellenweise. Beispielsweise bedeckt die Trennschicht 5 die von der Halbleiterschichtenfolge 2 abgewandte Hauptfläche der dünneren, ersten Teilbereiche der ersten elektrischen Anschlussschicht 4. Die Trennschicht ist elektrisch isolierend ausgebildet und weist beispielsweise ein Dielektrikum wie SiO₂, SiNₓ oder Si-ON auf oder besteht daraus.

Nachfolgend wird, wie in Figur 1D dargestellt, eine zweite elektrische Kontaktschicht 6 hergestellt. Ein Teilbereich der zweiten elektrischen Kontaktschicht 6 ist in der Vertiefung 3 angeordnet, und füllt diese vorzugsweise vollständig aus. Aufgrund der Auskleidung der Seitenwände der Vertiefung 3 mit der Trennschicht 5 tritt kein Kurzschluss der aktiven Zone 23 durch den in der Vertiefung 3 angeordneten Teilbereich der zweiten elektrischen Anschlussschicht 6 auf.

Die zweite elektrische Anschlussschicht 6 bedeckt in Draufsicht auf die zweite Hauptfläche 202 der Halbleiterschichtenfolge 2 die erste elektrische Kontaktschicht 4 stellenweise. Beispielsweise erstreckt sich die zweite elektrische Kontaktschicht von der Vertiefung 3 ausgehend über das erste Teilgebiet oder die ersten Teilgebiete der ersten elektrischen Anschlussschicht 4 in lateraler Richtung zu einem Randbereich der Halbleiterschichtenfolge 2. Zwischen der ersten und zweiten elektrischen Anschlussschicht 4, 6 ist dabei die Trennschicht 5 angeordnet, so dass kein elektrischer Kurzschluss zwischen der ersten und zweiten elektrischen Anschlussschicht 4, 6 auftritt.

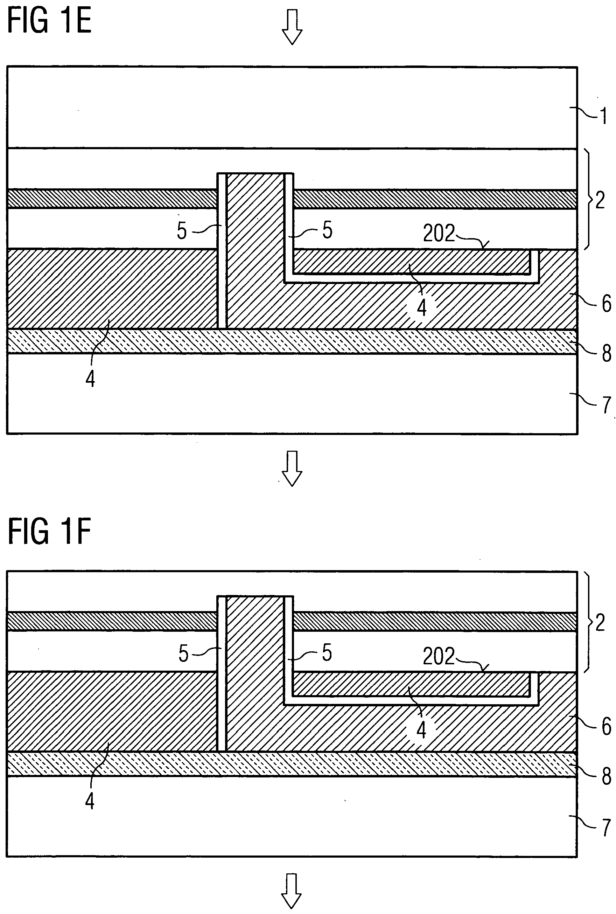

Wie in Figur 1E gezeigt, wird nachfolgend auf der vom Aufwachssubstrat 1 abgewandten Rückseite der Halbleiterschichtenfolge 2 ein Trägersubstrat 7 mittels einer Lot- oder Klebstoffschicht 8 auf der ersten und der zweiten elektrischen Anschlussschicht 4, 6 befestigt. Vorliegend weist die Klebstoffschicht 8 eine geringe elektrische Leitfähigkeit auf, insbesondere ist sie elektrisch isolierend. Das Trägersubstrat weist beispielsweise Aluminiumnitrid auf oder besteht daraus. Auch andere, insbesondere isolierende, Trägersubstrate 7, etwa Glasträgersubstrate sind denkbar.

Es ist auch denkbar, die Verbindung statt mit einer Klebstoffschicht mittels einer elektrisch leitfähigen Lotschicht herzustellen. Zweckmäßigerweise wird bei dieser Variante die Trennschicht 5 auch auf der dem Trägersubstrat 7 zugewandten Fläche der ersten und/oder zweiten elektrischen Anschlussschicht 4, 6 ausgebildet.

In einem nachfolgenden Verfahrensschritt (vergleiche Figur 1F) wird das Aufwachssubstrat gedünnt oder vollständig entfernt. Dies kann beispielsweise mittels eines dem Fachmann im Prinzip bekannten Laser-Abhebeverfahrens erfolgen. Hierzu weist das Aufwachssubstrat 1 oder die Halbleiterschichtenfolge 2 vorzugsweise eine Opferschicht auf, die bei Bestrahlung mit Laserstrahlung zersetzt wird, so dass das Aufwachssubstrat 1 abgesprengt wird. Die Bestrahlung mit Laserstrahlung erfolgt beispielsweise durch das Aufwachssubstrat 1 hindurch.

Schließlich wird die Halbleiterschichtenfolge 2 stellenweise entfernt, um elektrische Kontaktstellen 41, 61 der ersten beziehungsweise zweiten elektrischen Anschlussschicht 4, 6 freizulegen. Die Entfernung erfolgt zum Beispiel mittels eines Ätzprozesses, wobei sowohl Trockenätzprozesse als auch nasschemische Ätzprozesse geeignet sind.

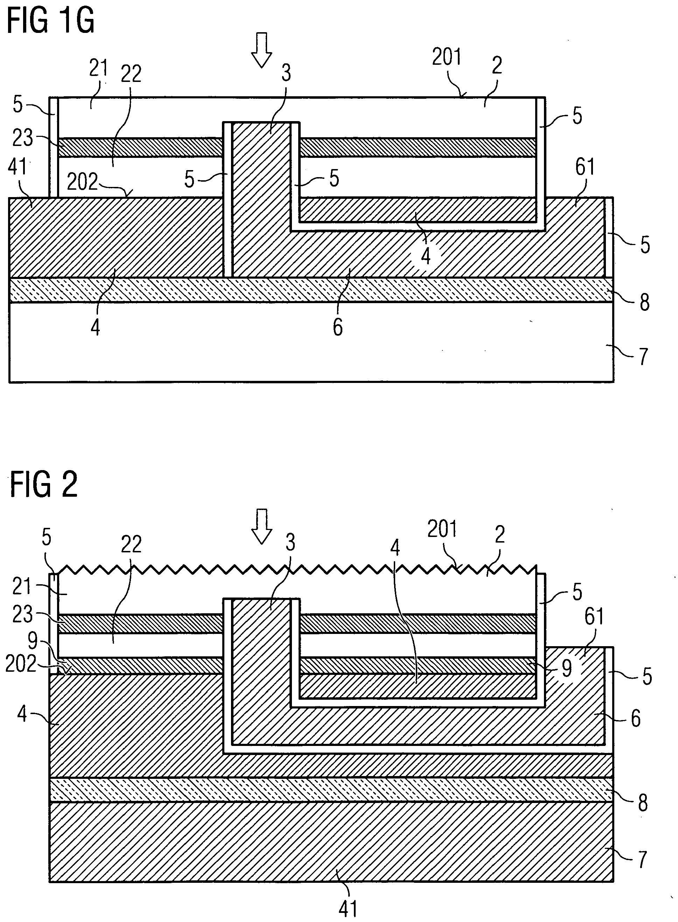

Bei einer Weiterbildung des Verfahrens werden die Seitenflanken der Halbleiterschichtenfolge 2, der ersten elektrischen Anschlussschicht 4 und/oder der zweiten elektrischen Anschlussschicht 6 ebenfalls mit einer elektrisch isolierenden Schicht 5 zumindest stellenweise, vorzugsweise jedoch vollständig bedeckt (siehe Figur 1G).

Der in Figur 1G dargestellte optoelektronische Halbleiterkörper gemäß dem ersten Ausführungsbeispiel ist dazu vorgesehen, von der aktiven Zone 23 im Betrieb erzeugte elektromagnetische Strahlung durch die erste Hauptfläche 201 der Halbleiterschichtenfolge 2 in Richtung seiner von dem Trägersubstrat 7 abgewandten Vorderseite zu emittieren. Von der aktiven Zone 23 in Richtung der Rückseite, also in Richtung der zweiten Hauptfläche 202, emittierte elektromagnetische Strahlung wird von der ersten elektrischen Anschlussschicht 4, der zweiten elektrischen Anschlussschicht 6 und/oder von der Trennschicht 5 in Richtung der Vorderseite zurück reflektiert.

Der Betriebsstrom zum Betrieb des optoelektronischen Halbleiterkörpers wird über die erste elektrische Kontaktstelle 41 und die zweite elektrische Kontaktstelle 61 von der Vorderseite her in die Halbleiterschichtenfolge eingeprägt. Die elektrischen Kontaktstellen 41, 61 sind vorliegend seitlich von der Halbleiterschichtenfolge 2 angeordnet.

Vorteilhafterweise befinden sich die elektrischen Kontaktstellen 41, 61 nicht im Strahlengang der in Richtung der Vorderseite emittierten elektromagnetischen Strahlung. Zugleich wird mittels der elektrischen Anschlussschichten 4, 6 eine besonders gute thermische Ankopplung an das Trägersubstrat 7 erzielt, so dass im Betrieb des Halbleiterkörpers erzeugte Verlustwärme besonders effizient von der Halbleiterschichtenfolge abgeführt wird.

Mittels der ersten elektrischen Kontaktstelle 41 und der ersten elektrischen Anschlussschicht 4 ist die Halbleiterschichtenfolge 2 vorliegend p-seitig kontaktiert. Die n-seitige Kontaktierung erfolgt vorliegend mittels der zweiten elektrischen Kontaktstelle 61 und der zweiten elektrischen Anschlussschicht 6. Die n- und die p-Seite der Halbleiterschichtenfolge 2, also insbesondere die n-dotierte Schicht 21 und die p-dotierte Schicht 22 können aber auch vertauscht sein.

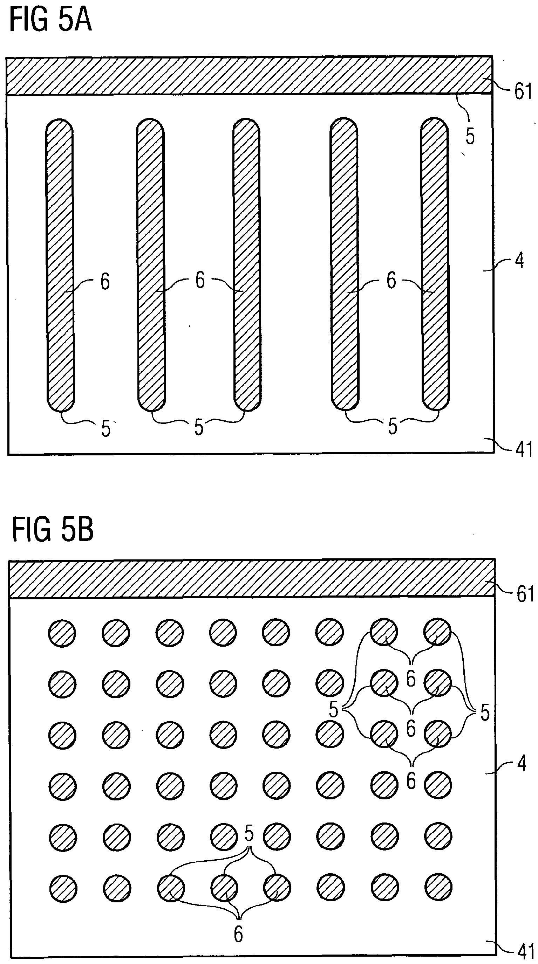

Die Figuren 5A und 5B zeigen verschiedene Varianten für die Form des Durchbruchs 3 durch die aktive Zone 23 in einer schematischen Draufsicht auf die Vorderseite des optoelektronischen Halbleiterkörpers gemäß der Figur 1G. Die Halbleiterschichtenfolge 2 ist dabei zur vereinfachten Darstellung weggelassen.

Bei der in Figur 5A dargestellten Variante haben die Vertiefungen 3 die Form von Gräben, von denen in Figur 1G zur vereinfachten Darstellung nur einer dargestellt ist. Die Teilbereiche der zweiten elektrischen Anschlussschicht 6, die sich durch die Durchbrüche 3 der aktiven Schicht 23 hindurch erstrecken, sind bei dieser Variante streifenförmig. Die erste Kontaktschicht 4 stellt, abgesehen von den Durchbrüchen 3, einen vollflächigen Kontakt mit der Halbleiterschichtenfolge 2 her.

Bei der in Figur 5B dargestellten Variante sind die Durchbrüche 3 nicht grabenförmig sondern haben die Form von Zylindern oder Kegelstümpfen. Dementsprechend haben auch die sich durch die Durchbrüche 3 der aktiven Schicht 23 erstreckenden Teilbereiche der zweiten elektrischen Anschlussschicht 6 einen kreisförmigen Querschnitt.

Sowohl bei dem Ausführungsbeispiel der Figur 5A wie auch bei dem der Figur 5B sind die elektrischen Kontaktstellen 41, 61 streifenförmig ausgeführt und erstrecken sich im Wesentlichen über eine gesamte Seitenlänge des Halbleiterkörpers.

Das in Figur 2 dargestellte zweite Ausführungsbeispiel eines optoelektronischen Halbleiterkörpers unterscheidet sich von dem ersten Ausführungsbeispiel dadurch, dass die Halbleiterschichtenfolge 2 an ihrer Vorderseite eine Aufrauung oder Strukturierung aufweist. Beispielsweise ist die erste Hauptfläche 201 strukturiert, etwa mittels pyramidenartigen, kegelartigen, pyramidenstumpf- und/oder kegelstumpfartigen Vorsprüngen und/oder Vertiefungen. Die Aufrauung beziehungsweise Strukturierung wirkt vorzugsweise als Diffusor für von der aktiven Zone 23 emittierte elektromagnetische Strahlung. Eine solche Aufrauung ist auch für die übrigen Ausführungsbeispiele geeignet, bei denen keine Aufrauung gezeigt ist.

Ein weiterer Unterschied zu dem ersten Ausführungsbeispiel besteht darin, dass die Halbleiterschichtenfolge 2 vorliegend eine Stromverteilungsschicht 9 an ihrer Rückseite aufweist. Die Stromaufweitungsschicht 9 weist vorzugsweise ein transparentes leitfähiges Oxid, beispielsweise Indium-Zinn-Oxid (ITO, Indium-Tin-Oxide) oder Indium-Zink-Oxid (IZO, Indium-Zinc-Oxide) auf. Beispielsweise wird die Stromaufweitungsschicht auf die epitaktisch gewachsenen Halbleiterschichten aufgedampft.

Vorteilhafterweise ist mittels der - wiederum auch für die übrigen Ausführungsbeispiele geeigneten - Stromaufweitungsschicht 9 die Homogenität des mittels der ersten elektrischen Anschlussschicht 4 in die Halbleiterschichtenfolge 2 im Betrieb eingeprägten Betriebsstroms weiter erhöht. Dies kann beispielsweise zweckmäßig sein, wenn die p-dotierte Schicht 22 keine ausreichende Querleitfähigkeit aufweist. In der Regel ist die Querleitfähigkeit der n-dotierten Schicht 21 höher als die der p-dotierten Schicht 22. Auf eine an die zweite elektrische Anschlussschicht 6 angrenzende Stromaufweitungsschicht ist daher bei dem vorliegenden zweiten Ausführungsbeispiel verzichtet.

Weiterhin im Gegensatz zum ersten Ausführungsbeispiel verläuft die zweite elektrische Anschlussschicht 6 bei dem zweiten Ausführungsbeispiel gemäß Figur 2 stellenweise im Inneren der ersten elektrischen Anschlussschicht 4. Mit anderen Worten folgen in Richtung von der Vorderseite zur Rückseite des optoelektronischen Halbleiterkörpers zunächst ein erstes Teilgebiet der ersten elektrischen Anschlussschicht 4, dann ein Teilbereich der zweiten elektrischen Anschlussschicht 6 und schließlich ein weiteres Teilgebiet der ersten elektrischen Anschlussschicht 4 aufeinander.

Zur Herstellung wird beispielsweise zunächst das erste Teilgebiet der ersten elektrischen Anschlussschicht 4 auf die Halbleiterschichtenfolge aufgebracht und mit einer Trennschicht 5 versehen. Anschließend wird die zweite elektrische Anschlussschicht ausgebildet. Dies erfolgt insbesondere analog zum ersten Ausführungsbeispiel (vergleiche Figuren 1C und 1D). Anschließend wird eine Trennschicht 5 auch auf die zweite elektrische Anschlussschicht 6 aufgebracht, bevor die erste elektrische Anschlussschicht 4 durch Ausbilden des auf die zweite elektrische Anschlussschicht 6 nachfolgenden Teilgebiets fertig gestellt wird.

Bei einer solchen Ausgestaltung wird vorteilhafterweise auch elektromagnetische Strahlung, die über die Trennschicht 5 in Richtung der Rückseite aus der Halbleiterschichtenfolge 2 austritt, zumindest teilweise in die Halbleiterschichtenfolge 2 - und damit in Richtung der Vorderseite - zurück reflektiert. Die Effizienz des Halbleiterkörpers ist auf diese Weise weiter erhöht.

Schließlich ist die erste elektrische Kontaktstelle 41 bei dem Ausführungsbeispiel der Figur 2 nicht zur Kontaktierung des Halbleiterkörpers von seiner Vorderseite her vorgesehen. Vielmehr weist der optoelektronische Halbleiterkörper gemäß dem zweiten Ausführungsbeispiel ein elektrisch leitfähiges Trägersubstrat 7 auf, das vorliegend mit einer Lotschicht 8, die ein Lötmetall wie AuZn aufweist, an der ersten elektrischen Anschlussschicht 4 mechanisch und elektrisch leitend befestigt ist. Auch ein elektrisch leitfähiger Klebstoff wie mit Silber gefüllter Epoxidharz-Klebstoff ist als Material für die Befestigungsschicht 8 geeignet. Mittels des Trägersubstrats ist der Halbleiterkörper, vorliegend p-seitig, über die erste elektrische Anschlussschicht 4 von seiner Rückseite her kontaktierbar. Die zweite elektrische Kontaktstelle 61 ist, wie beim ersten Ausführungsbeispiel, zur Kontaktierung von der Vorderseite her vorgesehen.

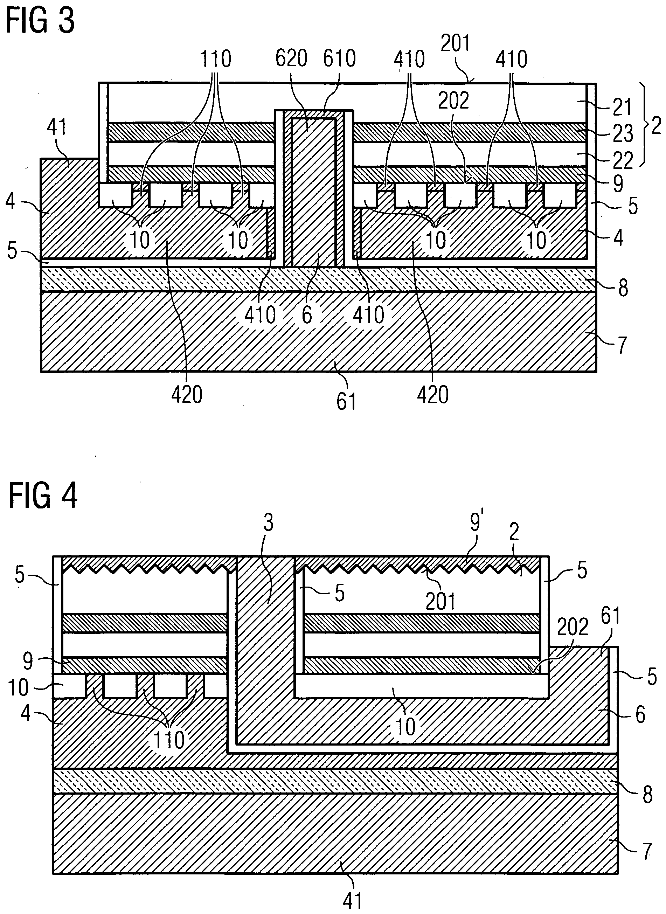

Bei dem in Figur 3 dargestellten dritten Ausführungsbeispiel ist statt der ersten elektrischen Kontaktschicht die zweite elektrische Kontaktschicht 6 elektrisch leitend mit dem Trägersubstrat 7 verbunden. Die erste elektrische Kontaktschicht 4 ist mittels der Trennschicht 5 von dem elektrisch leitenden Trägersubstrat 7 elektrisch isoliert.

Gemäß dem dritten Ausführungsbeispiel weisen die erste und die zweite elektrische Kontaktschicht 4, 6 eine Reflektorschicht 410 beziehungsweise 610 auf, die der Halbleiterschichtenfolge 2 benachbart ist und ein Metall mit einem hohen Reflexionskoeffizienten enthält, beispielsweise Silber, und eine Stromtransportschicht 420 beziehungsweise 620, die beispielsweise Gold aufweist.

Mittels der Reflektorschicht 410, 610 wird eine besonders effiziente Reflexion von elektromagnetischer Strahlung erzielt. Mit der Stromverteilungsschicht 420, 620 wird eine besonders verlustarme Zuleitung des Betriebsstroms zur Halbleiterschichtenfolge 2 erzielt.

Die Reflektorschicht hat vorzugsweise eine Dicke zwischen 50 nm und 200 nm, besonders bevorzugt zwischen 100 nm und 140 nm, wobei die Grenzen jeweils eingeschlossen sind. Die erste und/oder zweite elektrische Anschlussschicht 4, 6 kann zusätzlich eine Haftvermittlungsschicht aufweisen (in den Figuren nicht gezeigt). Die Haftvermittlungsschicht weist beispielsweise Platin oder Titan auf und hat zum Beispiel eine Dicke von 0,1 nm. Zweckmäßigerweise folgen die Reflektorschicht 410, 420 und die Stromtransportschicht 420, 620 der Haftvermittlungsschicht in Richtung von der Vorderseite zur Rückseite hin nach.

Bei dem vorliegenden Ausführungsbeispiel ist ein separates Trägersubstrat 7 mittels einer elektrisch leitfähigen Lot- oder Klebstoffschicht 8 auf einen Teilbereich der Trennschicht 5 und auf der zweiten elektrischen Anschlussschicht 6 befestigt. Alternativ kann jedoch auch die zweite elektrische Anschlussschicht 6 als Trägersubstrat 7 ausgebildet sein. Auf die Befestigungsschicht 8 kann dann verzichtet werden. Beispielsweise wird die zweite elektrische Anschlussschicht 6 mittels galvanischer Abscheidung derart verstärkt, dass sie ein mechanisch stabiles und insbesondere freitragendes Trägersubstrat 7 darstellt. Bei dieser Ausgestaltung weist der optoelektronische Halbleiterkörper vorzugsweise kein weiteres Trägersubstrat 7 auf. In analoger Weise kann bei diesem oder einem der anderen Ausführungsbeispiele auch die erste elektrische Anschlussschicht 4 zur Bildung eines Trägersubstrats 7 verstärkt werden.

Bei einer Variante des Halbleiterkörpers mit verstärkter erster und/oder zweiter elektrischer Anschlussschicht 4, 6 ist keine der beiden Anschlussschichten seitlich über die Halbleiterschichtenfolge hinaus geführt, um einen eine vorderseitige Anschlussfläche bereitzustellen. Der Halbleiterkörper weist die erste und die zweite Kontaktstelle 41, 61 dann zweckmäßigerweise an seiner Rückseite auf. Der Halbleiterkörper kann bei dieser Ausgestaltung alternativ oder zusätzlich zur Verstärkung der ersten und/oder zweiten elektrischen Anschlussschicht auch ein Trägersubstrat 7 an seiner Rückseite aufweisen, das rückseitig die erste und die zweite elektrische Kontaktstelle 41, 61 aufweist.

Ein weiterer Unterschied zwischen dem optoelektronischen Halbleiterkörper gemäß dem dritten Ausführungsbeispiel und den Halbleiterkörpern gemäß der ersten beiden Ausführungsbeispiele besteht darin, dass die Halbleiterschichtenfolge 2 an ihrer Rückseite eine halbleitende oder elektrisch isolierende Spiegelschicht 10 aufweist. Die Spiegelschicht 10 grenzt insbesondere an die zweite Hauptfläche 202 an oder ist dieser zumindest benachbart.

Die Spiegelschicht kann ein Dielektrikum wie SiO₂ enthalten. Ein Brechungsindex der Spiegelschicht und ein Brechungsindex einer an die zweite Hauptfläche 202 angrenzenden oder dieser zumindest benachbarten Schicht der Halbleiterschichtenfolge unterscheiden sich insbesondere um 1 oder mehr. Vorliegend enthält die Spiegelschicht 10 einen verteilten Bragg-Reflektor (DBR, Distributed Bragg-Reflector). Der verteilte Bragg-Reflektor weist mindestens ein Schichtenpaar mit alternierend hohem und niedrigem Brechungsindex auf. Bragg-Reflektoren aus dielektrischen Schichten sind dem Fachmann im Prinzip bekannt und werden daher an dieser Stelle nicht näher erläutert. Alternativ zu Schichtenpaaren aus dielektrischen Schichten kann der Bragg-Reflektor auch Schichtenpaare aus transparenten leitfähigen Oxiden wie ITO aufweisen. Eine Spiegelschicht 10 mit einem Bragg-Reflektor mit Schichtenpaaren aus transparenten leitfähigen Oxiden kann halbleitend oder sogar elektrisch leitfähig sein. Mittels der Spiegelschicht 10 wird eine besonders hohe Reflektivität erzielt.

Beispielsweise reflektieren die erste elektrische Anschlussschicht 4, die zweite elektrische Anschlussschicht 6 und gegebenenfalls die Spiegelschicht 10 80% oder mehr, vorzugsweise 90% oder mehr, und besonders bevorzugt 95% oder mehr der von der aktiven Schicht 23 in Richtung der Rückseite emittierten elektromagnetischen Strahlung in Richtung der Vorderseite zurück.

Die Spiegelschicht 10 bedeckt vorzugsweise 50 Prozent oder mehr der zweiten Hauptfläche 202 der Halbleiterschichtenfolge 2. Sie weist eine oder mehrere Öffnungen 110 auf, durch welche sich die erste elektrische Anschlussschicht 4 erstreckt. Im Bereich der Öffnungen 110 ist die erste elektrische Anschlussschicht 4 mit der Halbleiterschichtenfolge 2 elektrisch leitend verbunden. Vorzugsweise weist die Spiegelschicht 10 eine Mehrzahl von Öffnungen 110 auf, die unregelmäßig oder regelmäßig, beispielsweise an Gitterpunkten eines gedachten Gitters, angeordnet sein können. Die Abmessungen der Öffnungen sind vorzugsweise relativ gering, sie stellen dann so genannte Knüpfelkontakte für die elektrische Kontaktierung mittels der ersten elektrischen Anschlussschicht 4 dar.

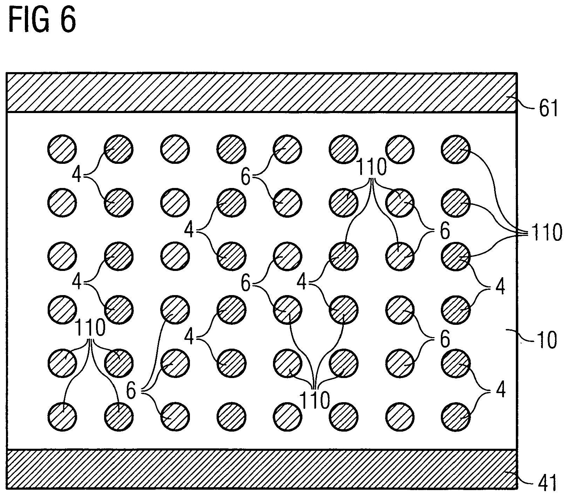

Eine solche Ausgestaltung ist in Figur 6 in Draufsicht auf die Vorderseite des Halbleiterkörpers gezeigt, wobei die Halbleiterschichtenfolge 2 mit der Stromverteilungsschicht 9 weggelassen ist. Im Unterschied zur Figur 3 ist der zweite elektrische Kontaktbereich 61 in Figur 6 nicht an der Rückseite des Halbleiterkörpers angeordnet, sondern analog zum ersten Ausführungsbeispiel zur Kontaktierung des Halbleiterkörpers von seiner Vorderseite her vorgesehen. Die elektrischen Kontaktbereiche 41, 61 erstrecken sich vorliegend im Wesentlichen über die gesamte Seitenlänge des Halbleiterkörpers.

Die Spiegelschicht 10 weist eine Mehrzahl von Öffnungen 110 auf, die vorliegend einen kreisförmigen Querschnitt haben. Die Öffnungen 110 sind an den Gitterpunkten eines gedachten rechteckigen oder quadratischen Gitters angeordnet. In ersten Öffnungen 110 sind Teilstücke der ersten elektrischen Anschlussschicht 4 angeordnet. Durch zweite Öffnungen 110 hindurch verläuft ein Teilbereich der zweiten elektrischen Anschlussschicht 6. Die ersten und die zweiten Öffnungen 110 sind vorliegend jeweils in Spalten angeordnet. Andere Anordnungen sind ebenfalls denkbar.

Bei einer Weiterbildung dieses Ausführungsbeispiels, die auch für die übrigen Ausführungsformen geeignet ist, ist die Trennschicht 5 zumindest stellenweise als elektrisch isolierende Spiegelschicht ausgebildet, welche insbesondere einen verteilten Bragg-Reflektor (DBR) aufweist. Beispielsweise ist zumindest ein in der Vertiefung 3 angeordnetes und/oder an diese angrenzendes Teilstück der Trennschicht 5 derart ausgebildet.

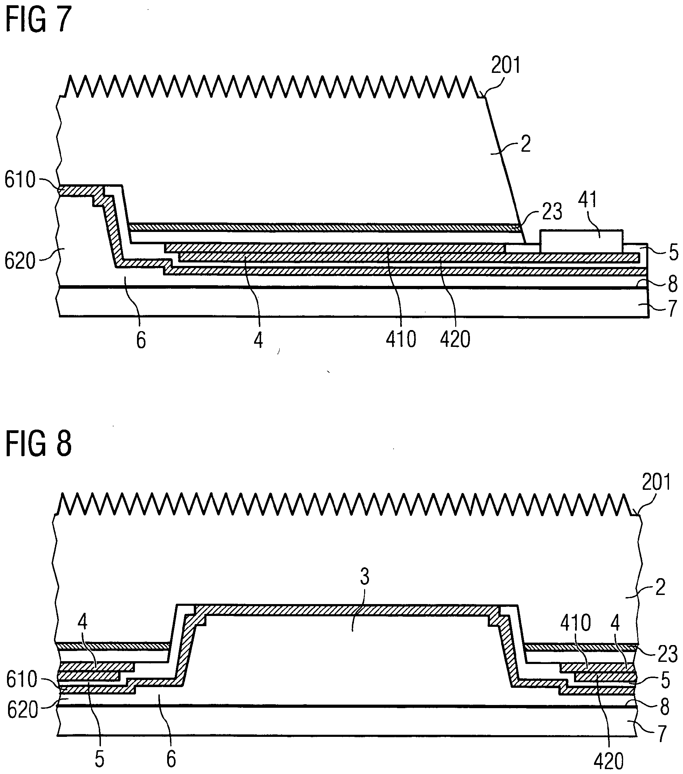

Ausschnitte des optoelektronischen Halbleiterkörpers der Figur 3 sind in den Figuren 7 und 8 schematisch dargestellt, wobei die Stromaufweitungsschicht 9 und die Spiegelschicht 10 zur vereinfachten Darstellung weggelassen sind.

Figur 7 zeigt einen Randbereich des Halbleiterkörpers mit der ersten elektrischen Kontaktstelle 41. Die Schnittdarstellung ist gegenüber Figur 3 um 180 Grad gedreht, so dass die erste elektrische Kontaktstelle 41 auf der rechten Seite der Figur 7 angeordnet ist. Die erste elektrische Kontaktstelle 41 ist als Bondpad ausgebildet. Bei der Herstellung des Halbleiterkörpers wird hierzu beispielsweise nach dem Entfernen des Randbereichs der Halbleiterschichtenfolge eine Öffnung in der Trennschicht 5 erzeugt und anschließend das Bondpad 41 in der Öffnung abgeschieden.

Figur 8 zeigt einen schematischen Querschnitt der grabenförmigen Vertiefung 3, deren Seitenwände von der Trennschicht 5 bedeckt sind.

Figur 4 zeigt ein viertes Ausführungsbeispiel eines optoelektronischen Halbleiterkörpers. Im Gegensatz zu den vorhergehenden Ausführungsbeispielen ist der Durchbruch 3 durch die aktive Zone 23 bei diesem Ausführungsbeispiel als über die gesamte Dicke der Halbleiterschichtenfolge 2 verlaufender Durchbruch ausgeführt. Der Durchbruch 3 erstreckt sich also vorliegend von der ersten Hauptfläche 201 bis zur zweiten Hauptfläche 202. Der Durchbruch stellt damit ein Loch oder einen Schlitz in der Halbleiterschichtenfolge 2 dar.

Auf der, vorliegend aufgerauten, ersten Hauptfläche 201 ist eine weitere Stromaufweitungsschicht 9', vorliegend zusätzlich zu der an der Rückseite der Halbleiterschichtenfolge 2 angeordneten Stromaufweitungsschicht 9, angeordnet. Die weitere Stromaufweitungsschicht 9' weist beispielsweise ebenfalls ein transparentes leitfähiges Oxid wie ITO auf. Mit der weiteren Stromaufweitungsschicht 9' wird eine besonders homogene Zufuhr des Betriebsstroms zur aktiven Zone 23 mittels der zweiten elektrischen Anschlussschicht 6 erzielt.

Wie beim dritten Ausführungsbeispiel weist auch der Halbleiterkörper gemäß dem vierten Ausführungsbeispiel eine Spiegelschicht 10 auf. Vorliegend ist die Spiegelschicht 10 alternativ oder zusätzlich zur Trennschicht 5 zwischen der zweiten Hauptfläche 202 der Halbleiterschichtenfolge 2 und der zweiten elektrischen Anschlussschicht 6 angeordnet.

Während bei den ersten drei Ausführungsbeispielen die zweite elektrische Anschlussschicht 6 in Richtung von der Rückseite zur Vorderseite zumindest durch einen Teilbereich der ersten elektrischen Anschlussschicht 4 verläuft, ist dies bei dem vierten Ausführungsbeispiel nicht der Fall. Bei dem vierten Ausführungsbeispiel überdeckt die erste Anschlussschicht 4 in Draufsicht auf die Rückseite des Halbleiterkörpers die zweite Anschlussschicht 6 zumindest stellenweise.

Die Erfindung ist nicht durch die Beschreibung anhand der Ausführungsbeispiele auf diese beschränkt.

## Patentansprüche

1. Optoelektronischer Halbleiterkörper mit einer Halbleiterschichtenfolge, die eine zur Erzeugung von elektromagnetischer Strahlung geeignete aktive Schicht aufweist, und einer ersten und einer zweiten elektrischen Anschlussschicht, wobei
- der Halbleiterkörper zur Emission elektromagnetischer Strahlung von einer Vorderseite vorgesehen ist,
- die erste und die zweite elektrische Anschlussschicht an einer der Vorderseite gegenüberliegenden Rückseite angeordnet und mittels einer Trennschicht elektrisch gegeneinander isoliert sind,
- die erste elektrische Anschlussschicht, die zweite elektrische Anschlussschicht und die Trennschicht lateral überlappen, und
- sich ein Teilbereich der zweiten elektrischen Anschlussschicht von der Rückseite durch einen Durchbruch der aktiven Schicht hindurch in Richtung zu der Vorderseite hin erstreckt, **dadurch gekennzeichnet, dass**
- die erste elektrische Anschlussschicht einen elektrischen Kontaktbereich aufweist, der zur elektrischen Kontaktierung des Halbleiterkörpers von seiner Vorderseite geeignet ist, und/ oder
- die zweite elektrische Anschlussschicht einen elektrischen Kontaktbereich aufweist, der zur elektrischen Kontaktierung des Halbleiterkörpers von seiner Vorderseite geeignet ist.

2. Optoelektronische Halbleiterkörper gemäß Anspruch 1, bei dem die erste und/oder die zweite elektrische Anschlussschicht einen von der aktiven Zone in Richtung zu der Rückseite hin emittierten Teil der elektromagnetischen Strahlung in Richtung der Vorderseite reflektieren.

3. Optoelektronische Halbleiterkörper gemäß einem der vorhergehenden Ansprüche, bei dem die Halbleiterschichtenfolge frei von einem Aufwachssubstrat ist.

4. Optoelektronischer Halbleiterkörper gemäß einem der vorhergehenden Ansprüche, der an seiner Rückseite ein Trägersubstrat aufweist.

5. Optoelektronischer Halbleiterkörper gemäß einem der vorhergehenden Ansprüche, wobei zwischen der Halbleiterschichtenfolge und der ersten und/oder der zweiten elektrischen Anschlussschicht zumindest stellenweise eine halbleitende oder elektrisch isolierende Spiegelschicht angeordnet ist, die eine Mehrzahl von Öffnungen aufweist, und die erste und/oder die zweite elektrische Anschlussschicht durch die Öffnungen zu der Halbleiterschichtenfolge verlaufen.

6. Optoelektronischer Halbleiterkörper gemäß einem der vorhergehenden Ansprüche, bei dem die Halbleiterschichtenfolge eine der Rückseite benachbarte Stromaufweitungsschicht aufweist, die ein transparentes leitfähiges Oxid enthält.

7. Optoelektronischer Halbleiterkörper gemäß einem der vorhergehenden Ansprüche, bei dem die erste und/oder die zweite elektrische Anschlussschicht eine Mehrschichtstruktur mit einer Haftvermittlungsschicht, einer Reflektorschicht und/oder einer Stromverteilungsschicht aufweist.

8. Optoelektronischer Halbleiterkörper gemäß einem der vorhergehenden Ansprüche, bei dem die erste oder die zweite elektrische Anschlussschicht einen elektrischen Kontaktbereich aufweist, der zur elektrischen Kontaktierung des Halbleiterkörpers von seiner Rückseite geeignet ist.

9. Optoelektronischer Halbleiterkörper gemäß einem der vorhergehenden Ansprüche, bei dem die Halbleiterschichtenfolge eine an der Vorderseite angeordnete Pufferschicht aufweist, die eine geringe elektrische Leitfähigkeit besitzt und undotiert oder schwach n-dotiert ist.

10. Verfahren zur Herstellung eines optoelektronischen Halbleiterkörpers mit den Schritten:
- Epitaktisches Aufwachsen einer Halbleiterschichtenfolge, die eine zur Erzeugung von elektromagnetischer Strahlung geeignete aktive Schicht aufweist und zur Emission elektromagnetischer Strahlung von einer Vorderseite vorgesehen ist, auf einem Aufwachssubstrat;
- Aufbringen einer ersten elektrischen Anschlussschicht an einer Rückseite der Halbleiterschichtenfolge;
- Ausbilden eines Durchbruchs in der aktiven Schicht;
- Ausbilden einer Trennschicht an der Rückseite der Halbleiterschichtenfolge; und
- Aufbringen einer zweiten elektrischen Anschlussschicht an der Rückseite der Halbleiterschichtenfolge,
wobei
- die erste elektrische Anschlussschicht, die Trennschicht und die zweite elektrische Anschlussschicht lateral überlappend ausgebildet werden,
- ein Teilbereich der zweiten elektrischen Anschlussschicht in dem Durchbruch ausgebildet wird, und
- die zweite elektrische Anschlussschicht mittels der Trennschicht von der ersten elektrischen Anschlussschicht elektrisch isoliert wird, **dadurch gekennzeichnet, dass**
- die erste elektrische Anschlussschicht einen elektrischen Kontaktbereich aufweist, der zur elektrischen Kontaktierung des Halbleiterkörpers von seiner Vorderseite geeignet ist, und/ oder
- die zweite elektrische Anschlussschicht einen elektrischen Kontaktbereich aufweist, der zur elektrischen Kontaktierung des Halbleiterkörpers von seiner Vorderseite geeignet ist.

11. Verfahren nach Anspruch 10, bei dem zumindest ein Teil des Aufwachssubstrats entfernt wird und an der Rückseite ein Trägersubstrat angeordnet oder ausgebildet wird.

12. Verfahren nach einem Ansprüche 10 bis 11, bei dem
- an der Rückseite der Halbleiterschichtenfolge stellenweise eine halbleitende oder elektrisch isolierende Spiegelschicht ausgebildet wird,
- eine Mehrzahl von Öffnungen in der halbleitenden oder elektrisch isolierenden Spiegelschicht ausgebildet wird, und
- die erste und/oder die zweite elektrische Anschlussschicht derart aufgebracht werden, dass sie durch die Öffnungen hindurch verlaufen.

13. Verfahren gemäß einem der Ansprüche 10 bis 12, bei dem das Epitaktische Aufwachsen der Halbleiterschichtenfolge das Aufwachsen einer Pufferschicht umfasst, die eine geringe elektrische Leitfähigkeit besitzt, zumindest ein Teil des Aufwachssubstrates entfernt wird und die Pufferschicht beim Entfernen des Aufwachssubstrats freigelegt wird.

## Claims

1. Optoelectronic semiconductor body comprising a semiconductor layer sequence which has an active layer suitable for generating electromagnetic radiation, and
a first and a second electrical connecting layer, wherein
- the semiconductor body is provided for emitting electromagnetic radiation from a front side,
- the first and the second electrical connecting layer are arranged on a rear side opposite the front side and are electrically insulated from one another by means of a separating layer,
- the first electrical connecting layer, the second electrical connecting layer and the separating layer laterally overlap, and
- a subarea of the second electrical connecting layer extends from the rear side through a recess in the active layer in the direction of the front side, **characterized in that**
- the first electrical connecting layer has an electrical contact area which is suitable for electrically contacting the semiconductor body from its front side, and/or
- the second electrical connecting layer has an electrical contact area which is suitable for electrically contacting the semiconductor body from its front side.

2. Optoelectronic semiconductor body according to Claim 1, in which the first and/or the second electrical connecting layer reflect in the direction of the front side a part of the electromagnetic radiation emitted in the direction of the rear side by the active
zone.

3. Optoelectronic semiconductor body according to one of the preceding claims, in which the semiconductor layer sequence is free of a growth substrate.

4. Optoelectronic semiconductor body according to one of the preceding claims, which has a carrier substrate on its rear side.

5. Optoelectronic semiconductor body according to one of the preceding claims, wherein a semiconducting or electrically insulating mirror layer is arranged at least in places between the semiconductor layer sequence and the first and/or the second electrical connecting layer, which mirror layer has a plurality of openings, and the first and/or the second electrical connecting layer extend through the openings to the semiconductor layer sequence.

6. Optoelectronic semiconductor body according to one of the preceding claims, in which the semiconductor layer sequence has a current spreading layer adjacent to the rear side, which current spreading layer contains a transparent conducting oxide.

7. Optoelectronic semiconductor body according to one of the preceding claims, in which the first and/or the second electrically connecting layer has a multi-layer structure having an adhesion promoting layer, a reflector layer and/or a current distribution layer.

8. Optoelectronic semiconductor body according to one of the preceding claims, in which the first or the second electrical connecting layer has an electrical contact area which is suitable for electrically contacting the semiconductor body from its rear side.

9. Optoelectronic semiconductor body according to one of the preceding claims, in which the semiconductor layer sequence has a buffer layer arranged on the front side, which has a low electrical conductivity and is undoped or weakly n-doped.

10. Method for producing an optoelectronic semiconductor body, comprising the following steps:
- epitaxial growing of a semiconductor layer sequence which has an active layer suitable for generating electromagnetic radiation and is provided for emitting electromagnetic radiation from a front side, on a growth substrate;
- applying a first electrical connecting layer on a rear side of the semiconductor layer sequence;
- forming a recess in the active layer;
- forming a separating layer on the rear side of the semiconductor layer sequence; and
- applying a second electrical connecting layer on the rear side of the semiconductor layer sequence,
wherein
- the first electrical connecting layer, the separating layer and the second electrical connecting layer are arranged to be laterally overlapping,
- a subarea of the second electrical connecting layer is formed in the recess, and
- the second electrical connecting layer is electrically insulated from the first electrical connecting layer by means of the separating layer, **characterized in that**
- the first electrical connecting layer has an electrical contact area which is suitable for electrically contacting the semiconductor body from its front side, and/or
- the second electrical connecting layer has an electrical contact area which is suitable for electrically contacting the semiconductor body from its front side.

11. Method according to Claim 10, in which at least a part of the growth substrate is removed and a carrier substrate is arranged or formed on the rear side.

12. Method according to one of Claims 10 to 11, in which
- a semiconducting or electrically insulating mirror layer is formed in places on the rear side of the semiconductor layer sequence,
- a plurality of openings is formed in the semiconducting or electrically insulating mirror layer,
and
- the first and/or the second electrical connecting layer are applied in such a manner that they extend through the openings.

13. Method according to one of Claims 10 to 12, in which the epitaxial growing of the semiconductor layer sequence comprises the growing of a buffer layer which has a low electrical conductivity, at least a part of the growth substrate is removed and the buffer layer is exposed when the growth substrate is removed.

## Revendications

1. Corps semi-conducteur optoélectronique comprenant une série de couches de semi-conducteur, qui comporte une couche active adaptée à la production de rayonnement électromagnétique, et une première et une seconde couche de connexion électrique, dans lequel
- le corps semi-conducteur est conçu pour émettre un rayonnement électromagnétique depuis une face avant,
- la première et la seconde couche de connexion électrique sont disposées sur une face arrière opposée à la face avant et sont isolées électriquement l'une de l'autre par une couche de séparation,
- la première couche de connexion électrique, la seconde couche de connexion électrique et la couche de séparation se chevauchent latéralement, et
- une zone partielle de la seconde couche de connexion électrique s'étend depuis la face arrière à travers une traversée dans la couche active dans la direction de la face avant, **caractérisé en ce que**
- la première couche de connexion électrique comporte une zone de contact électrique qui est adaptée à établir un contact électrique avec le corps semi-conducteur depuis sa face avant, et/ou
- la seconde couche de connexion électrique comporte une zone de contact électrique qui est adaptée à établir un contact électrique avec le corps semi-conducteur depuis sa face avant.

2. Corps semi-conducteur optoélectronique selon la revendication 1, dans lequel la première et/ou la seconde couche de connexion électrique réfléchissent dans la direction de la face avant une partie, émise par la couche active dans la direction de la face arrière, du rayonnement électromagnétique.

3. Corps semi-conducteur optoélectronique selon l'une quelconque des revendications précédentes, dans lequel la série de couches de semi-conducteur est dépourvue d'un substrat de croissance.

4. Corps semi-conducteur optoélectronique selon l'une quelconque des revendications précédentes, comportant un substrat de support sur sa face arrière.

5. Corps semi-conducteur optoélectronique selon l'une quelconque des revendications précédentes, dans lequel une couche miroir semi-conductrice ou électriquement isolante est disposée au moins par endroits entre la série de couches de semi-conducteur et la première et/ou la seconde couche de connexion électrique, laquelle couche miroir comporte une pluralité d'ouvertures, et la première et/ou la seconde couche de connexion électrique s'étendent à travers les ouvertures vers la série de couches de semi-conducteur.

6. Corps semi-conducteur optoélectronique selon l'une quelconque des revendications précédentes, dans lequel la série de couches de semi-conducteur comporte une couche d'étalement du courant voisine de la face arrière, qui contient un oxyde conducteur transparent.

7. Corps semi-conducteur optoélectronique selon l'une quelconque des revendications précédentes, dans lequel la première et/ou la seconde couche de connexion électrique comporte une structure multicouches ayant une couche adhésive, une couche réfléchissante et/ou une couche d'étalement du courant.

8. Corps semi-conducteur optoélectronique selon l'une quelconque des revendications précédentes, dans lequel la première ou la seconde couche de connexion électrique comporte une zone de contact électrique qui est adaptée à établir un contact électrique avec le corps semi-conducteur depuis sa face arrière.

9. Corps semi-conducteur optoélectronique selon l'une quelconque des revendications précédentes, dans lequel la série de couches de semi-conducteur comporte une couche tampon disposée sur la face avant, laquelle couche tampon possède une faible conductivité électrique et n'est pas dopée ou est faiblement dopée n.

10. Procédé de fabrication d'un corps semi-conducteur optoélectronique comprenant les étapes suivantes :
- la croissance épitaxiale d'une série de couches de semi-conducteur comportant une couche active adaptée à la production de rayonnement électromagnétique, et conçue pour émettre de rayonnement électromagnétique depuis une face avant, sur un substrat de croissance ;
- l'application d'une première couche de connexion électrique à une face arrière de la série de couches de semi-conducteur ;
- la formation d'une traversée dans la couche active ;
- la formation d'une couche de séparation sur la face arrière de la série de couches de semi-conducteur ; et
- l'application d'une seconde couche de connexion électrique sur la face arrière de la série de couches de semi-conducteur, dans lequel
- la première couche de connexion électrique, la couche de séparation et la seconde couche de connexion électrique sont formées de manière à se chevaucher latéralement,
- une zone partielle de la seconde couche de connexion électrique est formée dans la traversée, et
- la seconde couche de connexion électrique est électriquement isolée de la première couche de connexion électrique au moyen de la couche de séparation, **caractérisé en ce que**
- la première couche de connexion électrique comporte une zone de contact électrique adaptée à établir un contact électrique avec le corps semi-conducteur depuis sa face avant, et/ou
- la seconde couche de connexion électrique comporte une zone de contact électrique adaptée à établir un contact électrique avec le corps semi-conducteur depuis sa face avant.

11. Procédé selon la revendication 10, dans lequel au moins une partie du substrat de croissance est enlevée et un substrat de support est disposé ou formé sur la face arrière.

12. Procédé selon l'une quelconque des revendications 10 à 11, dans lequel
- une couche miroir semi-conductrice ou électriquement isolante est formée par endroits sur la face arrière de la série de couches de semi-conducteur,
- une pluralité d'ouvertures est formée dans la couche miroir semi-conductrice ou électriquement isolante, et
- la première et/ou la seconde couche de connexion électrique est appliquée de manière à ce qu'elle s'étende à travers les ouvertures.

13. Procédé selon l'une quelconque des revendications 10 à 12, dans lequel la croissance épitaxiale de la série de couches de semi-conducteur comprend la croissance d'une couche tampon qui possède une faible conductivité électrique, au moins une partie du substrat de croissance est enlevée et la couche tampon est libérée lors de l'enlèvement du substrat de croissance.
